# EUROPEAN PATENT APPLICATION

(11) **EP 3 889 631 A1**
(43) Date of publication of application: **06.10.2021**
(21) Application number: 20166960.3
(22) Date of filing: 31.03.2020
(51) Int. Cl.: G01R 33/34, G01R 33/3415

(54) **RADIO FREQUENCY PROBE FOR MAGNETIC RESONANCE**

(71) Applicant: Eidgenössische Technische Hochschule (ETH), 8092 Zürich (CH); Universität Zürich, 8006 Zürich (CH)
(72) Inventor: The designation of the inventor has not yet been filed
(74) Representative: Schmauder & Partner AG Patent- & Markenanwälte VSP

(57) **Abstract**

A radio frequency (RF) probe (2) for magnetic resonance (MR) signal detection comprises a stretchable conductor section (4). In order to provide improved shape adaptability, wearability and ease of handling, the stretchable conductor section is formed of a conductive elastomer.

## Description

### Field of the Invention

The present invention generally relates to a stretchable radio frequency (RF) probe for magnetic resonance applications, particularly for magnetic resonance imaging (MRI).

### Background of the Invention

For many uses of MRI, it is desirable to adapt the size and shape of RF coils to each patient's individual anatomy. To varying degrees, this can be achieved with rigid-adjustable [1-3] and flexible [4-12] designs. However, for true size adjustment and towards wearable designs, RF coils should additionally be stretchable. Stretchability has been implemented based on conductor length reserve using braided [13] or meandering [14] copper or conductive thread [15,16]. However, this turns out to pose limits on the amount of bendability, stretchability and conductivity achievable with a given configuration.

A more recent alternative is the use of liquid metal conductors. To form a coil, liquid metal can be printed onto a substrate [17] or contained in a stretchable tube [18], which simplifies sealing and removes the need for external restoring forces. The use of liquid metal implies a certain degree of risk associated with possible leakage, which would require cleanup and could lead to contact with toxic materials. There are also open questions about chemical stability of contact regions between the liquid metal and associated electrical conductors.

### Summary of the Invention

In view of the above, it is the principal object of the present invention to overcome the limitations and disadvantages of currently known methods and arrangements. Inventors have realized that, surprisingly, this can be achieved by exploiting the properties of certain conductive elastomers.

Conductive elastomers are basically known. In contrast to other types of flexible and stretchable conductors, conductive paths are formed through contact between particles such as carbon nanotubes [19-21], silver nanowires [22,23] or silver microparticles [24] embedded in an elastic polymer matrix [25-27]. According to percolation theory, above a certain density threshold the randomly distributed particles form a continuous electrical connection and thus render the elastomer conductive [28].

In the realm of MRI coil construction, it appears that so far the use of conductive elastomers was not considered due to the fact that the achievable conductivity is still relatively low by the standards of MRI technology. The present invention overcomes this prejudice.

Indeed, according to one aspect of this invention, there is provided a radio frequency (RF) probe for magnetic resonance (MR) signal detection comprising a stretchable conductor section, wherein said stretchable conductor section is formed of a conductive elastomer.

While sharing the advantages of liquid-metal tubes used in some types of RF probes, conductive elastomers obviate the issue of potential leakage. Moreover, the dry, inert material offers the possibility of simplified manufacturing and could even permit washable designs.

According to another aspect, a coil assembly for MR signal detection comprises:
- a sheet of flexible and stretchable dielectric material;
- at least one RF probe as defined above attached to and extending along said flexible sheet.

The term "at least one RF probe" implies the possibility of having a coil assembly comprising a plurality of RF probes. Such arrays are generally known and are also termed as "receiver arrays" or "probe arrays".

According to a further aspect, a device for MR signal detection comprises a coil assembly as defined above, wherein said coil assembly is provided with electrical connector ends that are connected to an electronic matching device selected from the group consisting of broadband matching devices, adjustable matching devices, automatic matching devices and mismatching devices for decoupling from other RF circuitry. Matching circuity will often also include means for detuning for operation with a volume transmitter.

As will be appreciated, such a device will be configured in such manner as to be compatible with a MR apparatus, particularly an MRI apparatus. The term "compatible" is intended to include compatibility in terms of materials, size, electrical and possibly nonelectrical connections. The electrical connector ends of the coil assembly may be directly located at respective ends of the stretchable conductor or on a separate electronic device which is coupled to the stretchable conductor in a contactless manner.

Unless explicitly mentioned otherwise, the terms "conductive", "conductivity" etc. shall be understood in relation to electrical conductivity.

Although the term "MR signal detection" is not per se limited to specific MR techniques, the present invention is primarily intended and applicable to MRI, i.e. to imaging techniques based on nuclear magnetic resonance.

Advantageous embodiments of the invention are defined in the dependent claims and are discussed in the description below.

Among the available conductive elastomers, it is preferable to select one having a volume resistivity (ρ_{Elastomer}) not exceeding 1*10⁵ Ωm, preferably not exceeding 7*10⁻⁶ Ωm (claim 2).

For certain embodiments one could envision using a stretchable conductor section that is substantially flat or film-like. In terms of conductivity, it is advantageous if the stretchable conductor section is substantially wire-shaped, preferably with an average cross-sectional size of 1 to 3 mm (claim 3). In the case of a wire with substantially circular, constant diameter, the term "average cross-sectional size" is equivalent to said diameter.

In most embodiments, the conductive elastomer comprises an elastomer matrix containing electrically conductive particles dispersed therein (claim 4).

The selection of elastomeric matrix material is generally governed by mechanical, chemical and processability considerations. In certain advantageous embodiments, the elastomeric matrix is selected from the group consisting of polydimethylsiloxane (PDMS), polyurethane and fluorinated silicone (claim 5). However, additional selection criteria emerge in the context of MRI applications. Depending on the type of nucleus being subjected to magnetic resonance, it may be useful to select an elastomeric matrix not containing such nuclei. In particular, when carrying out MRI with ¹H nuclei, one may use an elastomeric conductor based on a perfluorinated silicone polymer.

In general, the electrically conductive particles dispersed in the elastomeric matrix will consist of a metal with high electrical conductivity, preferably non-toxic and reasonably available. Therefore, according to an advantageous embodiment, the electrically conductive particles are silver particles (claim 6).

In order to be operated in a probe for MR signal detection, the stretchable conductor section, which will typically be shaped as a loop or coil, needs to be electrically coupled with an associated receiver. This could be accomplished in some "contactless" fashion, e.g. inductively, but in many cases it will be done with appropriate contacting connectors. Accordingly, in many embodiments of the invention the stretchable conductor section is provided with electrical connector ends (claim 7).

In certain embodiments of the coil assembly of this invention, the sheet of flexible and stretchable dielectric material is provided with at least one receiving pocket configured for receiving therein a corresponding RF probe (claim 9). Depending on application, it will be appropriate to secure the RF probe by appropriate securing means, preferably by releasable securing means such as snap-button or Velcro type systems.

Advantageously, the sheet of flexible and stretchable dielectric material is made from a textile and/or a polymeric material (claim 10). Moreover, the coil assembly, including of course the sheet, is preferably shaped to be wearable on a person's body region selected from the group consisting of knee, ankle, foot, hip, leg, wrist, hand, elbow, shoulder, arm, thorax, head and whole-body.

An important practical advantage of the present invention is the possibility of manufacturing coil assemblies that are compatible with wet cleaning, washing and disinfection (claim 12), which are important routine operations in a medical setting. Such operations require intimately contacting the device with some kind of treatment liquid without causing damage to its structure. It will be understood that such treatment liquid needs judicious selection, i.e. avoidance of strongly acidic, basic or corrosive/oxidizing liquids.

In certain embodiments of the device for MR signal detection of the present invention, the electronic matching device is insertable in an insertion pocket of the sheet of flexible and stretchable dielectric material (claim 14).

### Brief description of the drawings

The above mentioned and other features and objects of this invention and the manner of achieving them will become more apparent and this invention itself will be better understood by reference to the following description of various embodiments of this invention taken in conjunction with the accompanying drawings, which show the following:

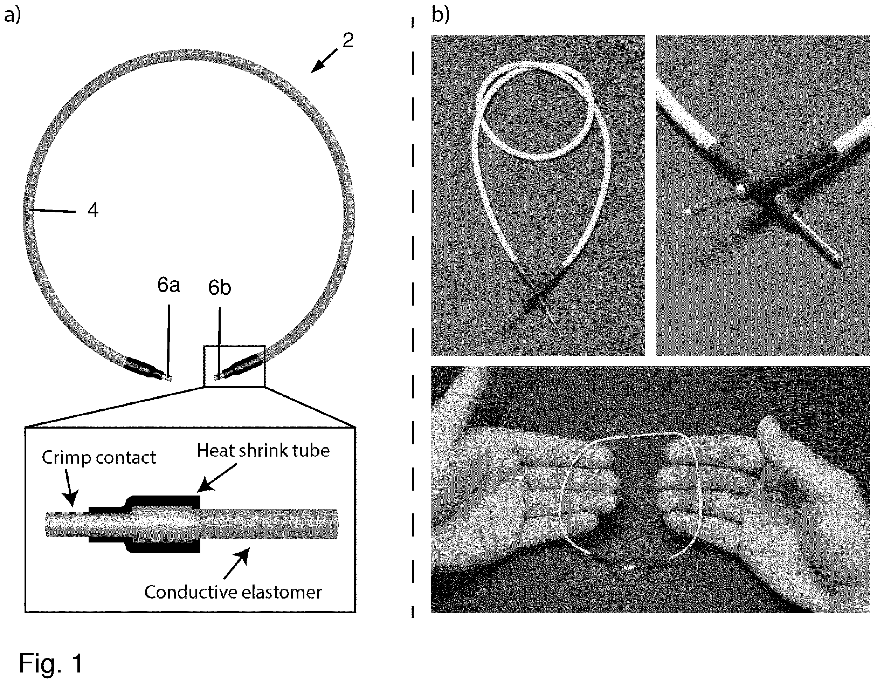

- Fig. 1: Conductive elastomer is obtained in the form of filaments. a) Filaments can be cut to length and electrical contact is formed by crimping. Heat shrink tube is applied. b) The resulting coil is very flexible and stretchable.

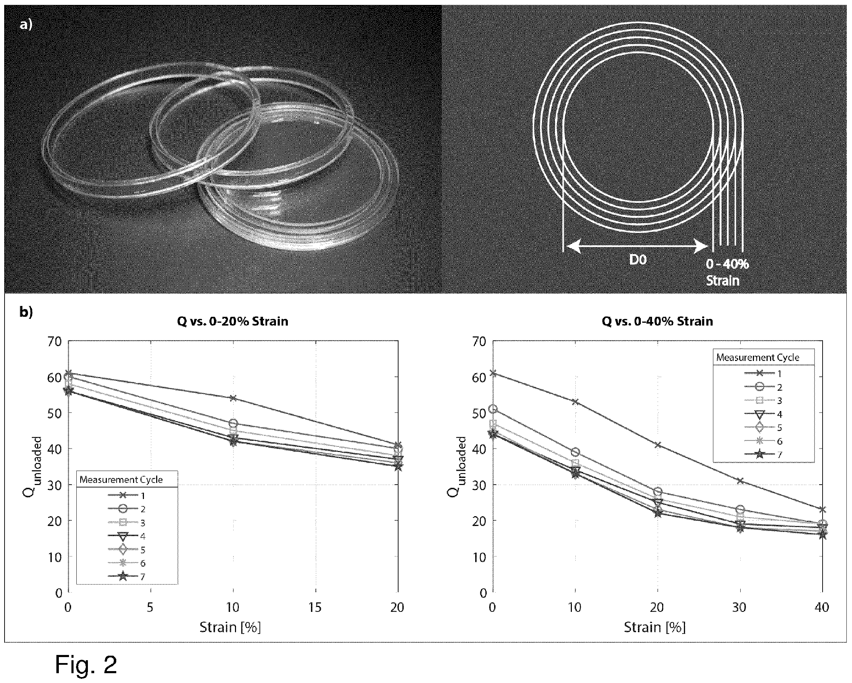

- Fig. 2: a) A laser-cut PMMA strain setup as previously used in Ref. [18] is employed for radial stretching of coils from 0 to 40%. b) The coils' unloaded Q was assessed to be 61 before any strain occurred. Upon strain the coils' Q converges to a value lower than before primary strain within ≈ 7 cycles of strain. Depending on the maximum strain applied to the conductive elastomer coil the resulting Q is lower, reaching values of 56 and 44 for a maximum repetitive strain of 20% or 40%, respectively.

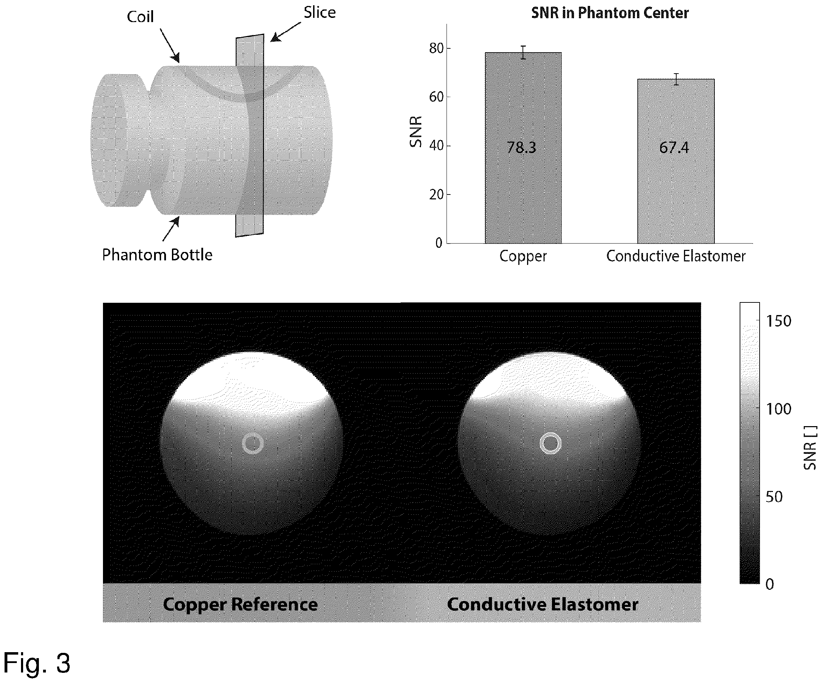

- Fig. 3: SNR maps were derived from phantom imaging with a copper (Q_{unloaded} = 439) and conductive elastomer (Q_{unloaded} = 76) coil, each with a conductor diameter of 2 mm (Gradient echo sequence: TR 30 ms, TE 4.8 ms, FA 30°, 1x1x5 mm, 1 slice). The SNR in the center of the loading phantom (770 mg/L CuSO₄ *5(H₂O), 2000 mg/L NaCl) was assessed to be 14% lower for the conductive elastomer coil compared to the copper reference coil, as expected due to the elastomer's lower conductivity.

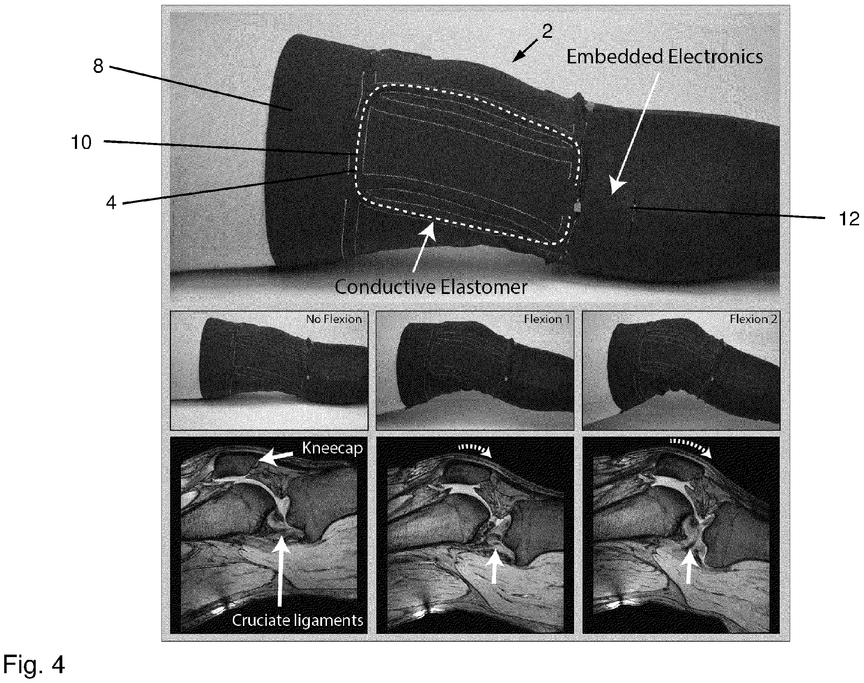

- Fig. 4: Two layers of athletic pants were sewn onto each other following a pattern that allows insertion of the four individual conductive elastomer coil elements. The array was tuned and matched for the straight knee position only. No further adjustments were made for the different flexion angles. In-vivo images of a volunteer's knee at three different flexion angles were acquired (Gradient echo sequence: TR 500 ms, TE 5.8 ms, FA 30°, 0.7x0.7x3 mm, scan duration 4:27 min). A B0 artifact is noticeable on the upper side of the thigh due to a ferromagnetic component in the coil connectors.

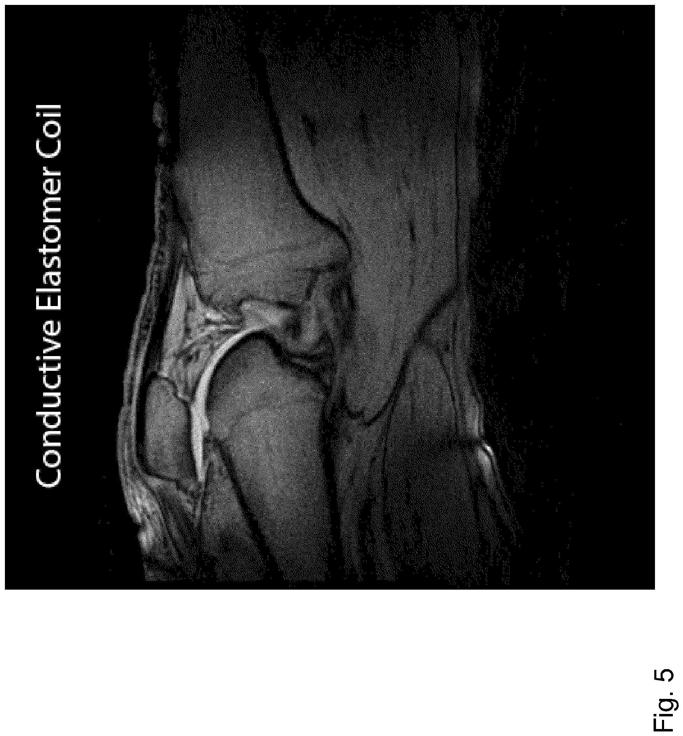

- Fig. 5: Dynamic in-vivo images of a volunteer's knee were acquired with an SPGR sequence (TR 7.8 ms, TE 3.8 ms, FA 7°, 1x1x5 mm, 1 slice, 30 dynamics, scan duration 1:08 min). Tuning and matching was performed only for the straight starting position of the knee. No further adjustments were made for flexion. The knee was continuously moved during image acquisition.

### Detailed description of the invention

As shown in Fig. 1a, a radio frequency (RF) probe 2 for MR signal detection comprises a stretchable conductor section 4, which is formed of a conductive elastomer. As also shown in the figure, the stretchable conductor section 4 is provided with electrical connector ends 6a, 6b.

As shown in Fig. 4, a coil assembly for MR signal detection, comprises a sheet of flexible and stretchable dielectric material 8 and an RF probe 2 attached to and extending along the flexible sheet. In the example shown, the sheet is configured for application on a patient's knee and is provided with a receiving pocket 10 configured for receiving therein the RF probe 2. Also shown in Fig. 4 is an electronic matching device inserted in an insertion pocket 12 of the sheet.

### Methods

### Conductive Elastomer

Filaments of a conductive elastomer based on silver microparticles (nanoleq AG, Zurich, Switzerland) were sourced at a diameter of 2 mm. The material is cut to the length of the coil segment and a solderable contact formed by crimping. Heat shrink tubing is applied (Fig. 1). The manufacturer specifies the material to be corrosion resistant, heat and cold resistant and washable. The volume resistivity of the material is specified as ρ_{Elastomer} = 7*10⁻⁶ Ωm. At DC this is a factor 417 higher than the resistivity of copper ρ_{Copper} = 1.68*10⁻⁸ Ωm. At 128 MHz, however, the skin depth of the elastomer δ_{Elastomer} = 117.7 µm is a factor of ≈20 larger than of copper δ_{Copper} = 5.8 µm. For two conductors of the same length L and diameter d (d>2*δ_{Elastomer}) this results in a resistance that is only ≈20 times larger for the elastomer conductor than for copper, despite the extreme difference in resistivity [4].

### Wearable Array Construction

Two layers of common highly elastic athletic pants were sewn onto each other following a pattern that forms stretchable casings that allow insertion of four coil elements in between the two layers (Fig. 4). The sewing pattern ensures approximate geometric decoupling which is complemented by preamplifier decoupling. The high-Z preamplifiers with low correlation resistance offer low noise figure at variable loading and π-matching networks accommodate frequency shifts upon stretching [1].

### Imaging

Images were obtained on a Philips 3T Ingenia system. SNR maps were calculated [1] from phantom images obtained with an elastomer coil and a copper coil for comparison, both based on conductors of 2 mm diameter (Fig. 3). In-vivo images of a healthy volunteer's knee were acquired at 3 different flexion angles (Fig. 4) and in a dynamic study with continuous flexion (Fig. 5).

### Results

The coils' unloaded Q was assessed at 61 before its first strain (Fig. 2). Upon strain the coils' Q converges to its final value within ≈ 7 strain cycles. Depending on the maximum strain applied to the conductive elastomer coil the final Q reaches values of 56 and 44 for a maximum repetitive strain of 20% or 40%, respectively. A Q_{unloaded}/Q_{loaded} ≈ 6 is observed by loading with a volunteer's thigh - sufficient for SNR efficient detection. The SNR in the center of a loading phantom was assessed to be 14% lower for the conductive elastomer coil compared to the copper reference coil, as expected due to the elastomer's lower conductivity (Fig. 3). In-vivo knee images, static (Fig. 4) and dynamic (Fig. 5), confirm sensitivity and coverage at different flexion angles and when flexed continuously.

### Discussion

The results of this study indicate that conductive elastomer is in fact a viable material for stretchable MR receive arrays and enables high-quality imaging. The favorable properties of elastomers come at an expense in terms of volume conductivity, which, however, is intrinsically mitigated by concomitant increase in skin depth. Upon repeated stretching by 20%, medium-size coil elements settled at an unloaded Q of approximately 40, which is still well above typical loaded Q at 3T and thus entails only a moderate SNR drawback. When necessary, a natural way of increasing the unloaded Q is to increase the conductor diameter, which was moderate here at 2 mm. Conductive elastomer poses no risk of leakage and is lightweight, easy to handle, and can readily be subject to washing and sanitization. These features make the material very attractive for wearable detection setups in conjunction with on-coil digitization and wireless transmission [29-34].

### References

1. J. A. Nordmeyer-Massner, N. De Zanche, and K. P. Pruessmann, "Mechanically adjustable coil array for wrist MRI," Magn. Reson. Med., vol. 61, no. 2, pp. 429-438, 2009.
2. W. E. Kwok, K. K. Lo, G. Seo, and S. M. S. Totterman, "A volume adjustable fourcoil phased array for high resolution MR imaging of the hip," Magn. Reson. Mater. Physics, Biol. Med., vol. 9, no. 1-2, pp. 59-64, 1999.
3. G. Adriany et al., "A geometrically adjustable 16-channel transmit/receive transmission line array for improved RF efficiency and parallel imaging performance at 7 Tesla," Magn. Reson. Med., vol. 59, no. 3, pp. 590-597, 2008.
4. J. A. Malko, E. C. McClees, I. F. Braun, P. C. Davis, and J. C. Hoffman, "A flexible mercury-filled surface coil for MR imaging," Am. J. Neuroradiol., vol. 7, no. 2, pp. 246-247, 1986.
5. J. Rousseau, P. Lecouffe, and X. Marchandise, "A new, fully versatile surface coil for MRI," Magn. Reson. Imaging, vol. 8, no. 4, pp. 517-523, 1990.
6. F. Jia, H. Yuan, D. Zhou, J. Zhang, X. Wang, and J. Fang, "Knee MRI under varying flexion angles utilizing a flexible flat cable antenna," NMR Biomed., vol. 28, no. 4, pp. 460-467, 2015.
7. D. Mager et al., "An MRI receiver coil produced by inkjet printing directly on to a flexible substrate," IEEE Trans. Med. Imaging, vol. 29, no. 2, pp. 482-487, 2010.
8. J. R. Corea et al., "Screen-printed flexible MRI receive coils," Nat. Commun., vol. 7, p. 10839, 2016.
9. S. S. Vasanawala et al., "Development and Clinical Implementation of Very Light Weight and Highly Flexible AIR Technology Arrays," in Proceedings of the 24th Annual Meeting of the ISMRM, 2016, pp. 3-5.
10. B. Zhang, D. K. Sodickson, and M. A. Cloos, "A high-impedance detector-array glove for magnetic resonance imaging of the hand," Nat. Biomed. Eng., vol. 2, no. August, pp. 1-8, 2018.
11. L. Nohava et al., "Flexible multi-turn multi-gap coaxial RF coils (MTMG-CCs): design concept and bench validation," Proc. 27th Annu. Meet. ISMRM, Montreal, Canada, nr. 3903, pp. 3-5, 2019.
12. M. Obermann et al., "Ultra-flexible and light-weight 3-channel coaxial transmission line resonator receive-only coil array for 3T," Proc. 27th Annu. Meet. ISMRM, Montreal, Canada, vol. 6, no. I, pp. 2018-2019, 2019.
13. J. A. Nordmeyer-Massner, N. De Zanche, and K. P. Pruessmann, "Stretchable coil arrays: Application to knee imaging under varying flexion angles," Magn. Reson. Med., vol. 67, no. 3, pp. 872-879, 2012.
14. B. Gruber and S. Zink, "Anatomically adaptive local coils for MRI Imaging - Evaluation of stretchable antennas at 1.5T," Proc. 24th Annu. Meet. ISMRM, p. 543, 2016.
15. J. Vincent and J. Rispoli, "Stretchable and Flexible Conductive-Thread Based Radiofrequency Coils for Magnetic Resonance Imaging," Proc. Intl. Soc. Mag. Reson. Med. 27, p. 1490, 2019.
16. B. Kahraman Agir, B. Bayrambas, K. Yegin, and E. Ozturk Isik, "Wearable and stretchable surface breast coil," Proc. Intl. Soc. Mag. Reson. Med. 27, pp. 2-4, 2019.
17. M. Varga et al., "Adsorbed Eutectic Galn Structures on a Neoprene Foam for Stretchable MRI Coils," Adv. Mater., vol. 29, no. 44, pp. 1-7, 2017.
18. A. Port et al., "Liquid metal in stretchable tubes: A wearable 4-channel knee array," Proc. Intl. Soc. Mag. Reson. Med. 27, p. 1114, 2019.
19. M. K. Shin, J. Oh, M. Lima, M. E. Kozlov, S. J. Kim, and R. H. Baughman, "Elastomeric conductive composites based on carbon nanotube forests," Adv. Mater., vol. 22, no. 24, pp. 2663-2667, 2010.
20. D. J. Lipomi et al., "Skin-like pressure and strain sensors based on transparent elastic films of carbon nanotubes," Nat. Nanotechnol., vol. 6, no. 12, pp. 788-792, 2011.
21. T. Yamada et al., "A stretchable carbon nanotube strain sensor for human-motion detection," Nat. Nanotechnol., vol. 6, no. 5, pp. 296-301, 2011.
22. F. Stauffer and K. Tybrandt, "Bright Stretchable Alternating Current Electroluminescent Displays Based on High Permittivity Composites," Adv. Mater., pp. 7200-7203, 2016.
23. V. Martinez, F. Stauffer, M. O. Adagunodo, C. Forro, J. Vörös, and A. Larmagnac, "Stretchable Silver Nanowire-Elastomer 29-34 Composite Microelectrodes with Tailored Electrical Properties," ACS Appl. Mater. Interfaces, vol. 7, no. 24, pp. 13467-13475, 2015.
24. F. Stauffer et al., "Skin Conformal Polymer Electrodes for Clinical ECG and EEG Recordings," Adv. Healthc. Mater., vol. 7, no. 7, pp. 1-10, 2018.
25. Y. L. Park, Soft Wearable Robotics Technologies for Body Motion Sensing. Elsevier Inc., 2016.
26. Y. P. Mamunya, V. V Davydenko, P. Pissis, and E. V Lebedev, "Electrical and thermal conductivity of polymers filled with metal powders," Eur. Polym. J., vol. 38, pp. 1887-1897, 2002.
27. G. Harsanyi, "Polymer films in sensor applications: a review of present uses and future possibilities," Sens. Rev., vol. 20, no. 2, p. 98, 2000.
28. S. Choi, S. I. Han, D. Kim, T. Hyeon, and D. H. Kim, "High-performance stretchable conductive nanocomposites: Materials, processes, and device applications," Chem. Soc. Rev., vol. 48, no. 6, pp. 1566-1595, 2019.
29. A. Port et al., "Towards wearable MR detection: A stretchable wrist array with on-body digitization," in Proc. Joint Annual Meeting ISMRM-ESMRMB, Paris, France, 2018, p. 17.
30. B. Sporrer et al., "A Fully Integrated Dual-Channel On-Coil CMOS Receiver for Array Coils in 1.5-10.5 T MRI," IEEE Trans. Biomed. Circuits Syst., 2017.
31. K. Aggarwal et al., "A Millimeter-Wave Digital Link for Wireless MRI," IEEE Trans. Med. Imaging, 2016.
32. G. Scott, S. Vasanawala, F. Robb, P. Stang, and J. Pauly, "Pilot Tone Software Synchronization for Wireless MRI Receivers," in Proc. Joint Annual Meeting ISMRM-ESMRMB, Paris, France, 2018, pp. 4-6.
33. A. Reykowski et al., "High Precision Wireless Clock Recovery for On-Coil MRI Receivers Using Round- Trip Carrier Phase Tracking," in Proc. Joint Annual Meeting ISMRM-ESMRMB, Paris, France, 2018, pp. 2-5.
34. C. Vassos, F. Robb, S. Vasanawala, J. Pauly, and G. Scott, "Characterization of In-Bore 802.11 ac Wi-Fi Performance," in Proc. Intl. Soc. Mag. Reson. Med. 27, 2019.

## Claims

1. A radio frequency (RF) probe (2) for magnetic resonance (MR) signal detection, comprising a stretchable conductor section (4), **characterized in that** the stretchable conductor section is formed of a conductive elastomer.

2. The RF probe according to claim 1, wherein the conductive elastomer has a volume resistivity (ρ_{Elastomer}) not exceeding 1*10⁻⁵ Ωm, preferably not exceeding 7*10⁻⁶ Ωm.

3. The RF probe according to claim 1 or 2, wherein the stretchable conductor section is substantially wire-shaped, preferably with an average cross-sectional size of 1 to 3 mm.

4. The RF probe according to one of claims 1 to 3, wherein the conductive elastomer comprises an elastomer matrix containing electrically conductive particles dispersed therein.

5. The RF probe according to claim 4, wherein the elastomer is selected from the group consisting of polydimethylsiloxane (PDMS), polyurethane and fluorinated silicone.

6. The RF probe according to claim 4 or 5, wherein the electrically conductive particles are metallic particles, particularly silver particles.

7. The RF probe according to one of claims 1 to 6, wherein said stretchable conductor section (4) is provided with electrical connector ends (6a, 6b).

8. A coil assembly for MR signal detection, comprising:
- a sheet of flexible and stretchable dielectric material (8);
- at least one RF probe (2) according to one of the preceding claims attached to and extending along said flexible sheet.

9. The coil assembly according to claim 8, wherein said sheet is provided with receiving pockets (10) each configured for receiving therein one of said attached RF probes.

10. The coil assembly according to claim 8 or 9, wherein said sheet is made from a textile and/or a polymeric material.

11. The coil assembly according to one of claims 8 to 10, which is shaped to be wearable on a person's body region selected from the group consisting of knee, ankle, foot, hip, leg, wrist, hand, elbow, shoulder, arm, thorax, head and whole-body.

12. The coil assembly according to one of claims 8 to 11, which is compatible with wet cleaning, washing and disinfection.

13. A device for MR signal excitation or detection, comprising a coil assembly according to one of claims 8 to 12, wherein said coil assembly is provided with electrical connector ends that are connected to an electronic matching device selected from the group consisting of broadband matching devices, adjustable matching devices, automatic matching devices and mismatching devices for decoupling from other RF circuitry.

14. The device according to claim 13, wherein said electronic matching device is insertable in an insertion pocket (12) of said sheet.
